# EUROPÄISCHE PATENTSCHRIFT

(11) **EP 2 844 048 B1**
(45) Veröffentlichungstag und Bekanntmachung des Hinweises auf die Patenterteilung: **12.04.2017**
(21) Anmeldenummer: 14180745.3
(22) Anmeldetag: 13.08.2014
(51) Int. Cl.: H05K 7/14

(54) **Kartenführung für einen Baugruppenträger und Baugruppenträger**
Card guide for module holders and holder
Guide-cartes pour supporter un châssis et châssis

(30) Priorität: 26.08.2013 EP 13181737
(43) Veröffentlichungstag der Anmeldung: 04.03.2015
(73) Patentinhaber: ELMA Electronic AG, 8620 Wetzikon (CH)
(72) Erfinder: Ruoss, Urs, 8623 Wetzikon (CH); Birrer, Adrian, 8400 Winterthur (CH); Graber, Lina, 8620 Wetzikon (CH)
(74) Vertreter: Intellectual Property Services GmbH

(56) Entgegenhaltungen:
- WO-A1-87/05776
- FR-A5- 2 116 630
- US-A- 4 007 403
- US-A- 5 700 342
- US-A1- 2010 097 773

## Beschreibung

Die Erfindung betrifft eine Kartenführung für einen Baugruppenträger gemäss dem Oberbegriff des unabhängigen Anspruchs 1 und einen Baugruppenträger gemäss dem Oberbegriff des unabhängigen Anspruchs 10.

Derartige Baugruppenträger werden beispielsweise zum Aufbau einer Rechnereinheit oder mit Leistungselektronik versehenen elektronischen Geräten verwendet. Dabei ist bekannt, dass mit elektronischen Bauteilen bestückte Steckkarten bzw. Leiterplatten innerhalb eines Gehäuses in Kartenführungen aufgenommen und beispielsweise über eine gemeinsame Back Plane kontaktiert werden.

Die Kartenführung umfasst für gewöhnlich ein Führungselement und einen Kontakthalter für ein Kontaktelement. Das Führungselement weist einen Führungsfuss auf, um eine sich in eine Einschubrichtung erstreckende Schmalseite der Steckkarte zu führen, wobei zur Führung der Arbeitsflächen auf einer Seite des Führungsfusses ein seitlicher Führungshalter vorgesehen ist. Die Kartenführungen sind meistens in einem Kopf- oder Bodenteil angeordnet und üblicherweise aus getrennten Einzelteilen zusammengesetzt, so dass deren Herstellung sehr kompliziert und teuer ist. Die üblicherweise eingesetzten getrennten und bekannten Kartenführungen bei einem Baugruppenträger sind beispielsweise in der WO 00/2879 oder EP 1 441 579 A1 gezeigt.

Aus der DE 10 2004 054 338 A1 ist ein Baugruppenträger mit nebeneinander angeordneten und in Einschubrichtung ausgerichteten Kartenführung zur Aufnahme einer Leiterplatte einer Steckbaugruppe bekannt. Die Kartenführung ist einstückig und es sind mehrere Führungselemente gezeigt. Die Kartenführung ist dabei derart ausgestaltet, dass das Führungselement aus einem Führungsfuss und jeweils zwei in eine Einschubrichtung verlaufenden beabstandeten Reihen von mehreren Führungshaltern gebildet ist. Das Kontaktelement ist dabei als ein von der Kartenführungen separates Bauteil ausgeführt.

Aus der US 2010/0097773 A1 und WO 87/05776 A1 sind einteilige Kartenführungen zum Führen und Kontaktieren einer Steckkarte bekannt. Die Kartenführung umfasst ein Paar integral ausgebildete Seitenwände und mindestens ein Paar von Kontaktelementen, welche als Teil der Seitenwände ausgebildet sind, um die Steckkarte zu kontaktieren.

Eine ähnliche Kartenführung, allerdings nicht einteilig, ist in der FR 2.116.630 A5 offenbart. Aus der FR 2.116.630 A5 ist also eine Kartenführung mit Seitenwänden und mindestens einem Paar von Kontaktelementen bekannt, wobei die Kontaktelemente als Teil der Seitenwände ausgebildet sind, um die Steckkarte zu kontaktieren.

Eine einteilige Kartenführung zum Führen einer Steckkarte aber ohne Kontaktierung der Steckkarte ist aus der US 4 007 403 A bekannt. Die US 5,700,342 A offenbart eine Kartenführung aus einem Verbundmaterial mit einer integrierten Kühlung.

Die Kartenführung ist dabei derart ausgestaltet, dass das Führungselement aus einem Führungsfuss und jeweils zwei in eine Einschubrichtung verlaufenden beabstandeten Reihen von mehreren Führungshaltern gebildet ist. Das Kontaktelement ist dabei als ein von der Kartenführungen separates Bauteil ausgeführt.

Es ist Aufgabe der Erfindung, eine Kartenführung für einen Baugruppenträger so zu vereinfachen, dass die Kartenführung einfacher herstellbar ist und / oder billiger und / oder einfacher ausgeführt ist und / oder auf einfache Weise eine federnde Kontaktgabe zu den Steckkarten erreicht werden kann.

Diese Aufgabe wird durch eine Kartenführung für einen Baugruppenträger mit den Merkmalen des Anspruchs 1 und einen Baugruppenträger mit den Merkmalen des Anspruchs 10 gelöst.

Erfindungsgemäss wird eine Kartenführung für einen Baugruppenträger zum Führen und Halten einer zu einer Einschubeinheit gehörenden Steckkarte vorgeschlagen. Die Steckkarte zwei gegenüberliegende Arbeitsflächen und vier Schmalseiten aufweist. Die Kartenführung umfasst ein Führungselement und einen Kontakthalter für ein Kontaktelement. Das Führungselement weist einen Führungsfuss auf, um eine sich in eine Einschubrichtung erstreckende Schmalseite der Steckkarte zu führen, wobei zur Führung der Arbeitsflächen auf einer Seite des Führungsfusses ein seitlicher Führungshalter vorgesehen ist. Die Kartenführung ist einteilig ausgeführt.

Die Kartenführung umfasst ein Führungselement. Das Führungselement weist einen Führungsfuss und einen seitlichen Führungshalter auf. Das Führungselement kann beispielsweise als eine überwiegend u-förmige Führungsschiene ausgebildet sein. Der Führungsfuss kann als eine ebene Gleitfläche für eine der vier orthogonalen Schmalseiten der Steckkarte ausgeführt sein. Die Gleitfläche des Führungsfusses kann aber auch eine konkave oder konvexe Wölbung aufweisen. Der Führungsfuss kann rechteckig oder rechteckig mit abgerundenten Ecken sein. Der Führungsfuss kann aus mehreren zusammenhängenden Einzelteilen oder aber als ein ganzes Bauteil ausgeführt sein. Der Führungsfuss stellt somit eine zuverlässige Führung der Schmalseite der Steckkarte sicher.

Der seitliche Führungshalter kann zur Führung und Stabilisierung der Arbeitsfläche der Steckkarte ausgeführt sein. Es können ein seitlicher Führungshalter oder auch zwei oder mehrere Führungshalter vorgesehen sein. Die Führungshalter können entweder auf einer oder beiden Seiten des Führungsfusses angeordnet sein. Pro Führungselement können eine oder zwei Reihen von Führungshaltern ausgeführt sein. Die seitlichen Führungshalter der beiden Reihen eines Führungselements können in eine Einschubrichtung paarweise einander gegenüber stehen. Zwei oder mehrere seitliche Führungshalter können dabei über die gesamte Länge des Führungsfusses einen gleichen Abstand aufweisen oder aber leicht so geneigt sein, dass der Abstand der Führungshalter zu einer Einführseite hin leicht zunimmt. Der Abstand kann vorteilhafterweise an die Dicke der Steckkarte angepasst sein. Damit kann eine Einschubreibung für die Steckkarte klein gehalten werden. Auf der Einführseite kann ein Paar von Führungshaltern eine Einführöffnung als eine Art Einführaufnahme ausbilden. Dieses Paar von Führungshaltern im Einführbereich des Führungselements kann zusätzlich zu einer Neigung nach ihren Außenseiten schräg ausgeformt sein, so dass die einander zugekehrten Seitenflächen in Einschubrichtung in einem spitzen Winkel zueinander stehen. Daher ist ihr Abstand an der Anfangsfront größer als an der Endfront, so dass die sich verengende Einführaufnahme gebildet wird. Diese Einführaufnahme geht am Ende in die Dicke der Steckkarte über. Vorteilhafterweise kann sich die Steckkarten somit beim Ein- bzw. Ausschieben nicht verhaken. Dabei bilden die Führungshalter keine oder keine großen Gegenkräfte, so dass die Steckkarte leicht eingesteckt werden kann.

Die Kartenführung kann als ein einfaches Stanz-Biegeteile in einem einfachen, unkomplizierten Vorgang hergestellt werden, da praktisch nur in Stanzrichtung auch die wesentlichen Biegevorgänge durchgeführt werden können. Das Führungselement, insbesondere der Führungsfuss und der Führungshalter können einfach ausgestanzt und hochgekantet werden. Die Kartenführung kann an einer der freien Endkanten oder an beiden freien Endkanten einen Verbindungssteg aufweisen und somit kann die Kartenführung mehreren miteinander verbundenen Führungselemente und Kontakthaltern umfassen. Der Verbindungssteg kann treppenförmig geformt sein. Ebenso kann der Verbindungssteg einen Aufnahmebereich ausbilden, beispielsweise ein Loch, um beispielsweise Kontaktstifte einer Frontplatte aufzunehmen. Die Kartenführung kann aber auch aus Kunststoff sein und mittels eines Spritzgussverfahrens herstellbar sein.

Die Kartenführung umfasst ausserdem einen Kontakthalter für ein Kontaktelement. Der Kontakthalter für das Kontaktelement kann eine der Arbeitsflächen der Steckkarte mit der Kartenführung kontaktieren, als ein Federlement ausgebildet sein und am Führungshalter angeordnet sein. Das Federelement kann Anlagekontaktsteile oder ein Federblatt umfassen und in die Führungsschiene ragen. Der Kontakthalter kann die Kontaktierung zwischen der Steckkarte und der Kartenführung herstellen. Der Kontakthalter kann als ein Teil des Führungsfusses, bevorzugt als ein Teil des Führungshalters ausgebildet sein, insbesondere in einer Ausnehmung am Führungshalter angeordnet sein. Der Kontakthalter kann aber auch am Verbindungssteg angeordnet sein und eine Frontplatte und/oder einen Führungsstift und/oder ein mit der Frontplatte verbundenes Metallteil der Einschubeinheit kontaktieren. Der Kontakthalter kann einstückig oder mehrstückig sein.

Die Kartenführung ist einteilig ausgeführt, wobei die Kartenführung das Führungselement und / oder den Kontakthalter und / oder den Verbindungssteg umfasst. Vorteil ist, dass die Kartenführung mit dem Führungselement, dem Kontakthalter und / oder dem Verbindungssteg in einem einfachen Stanz-Biege-Vorgang aus einem plattenförmigen Basisteil hergestellt werden können. Ausserdem kann die Anzahl der Aufbauteile der Kartenführung für den Baugruppenträger beachtlich reduziert werden. Zudem wird dadurch auch der Montageaufwand verringern.

Die Steckkarte umfasst zwei gegenüberliegende Arbeitsflächen und dazu vier Schmalseiten. Die Steckkarte kann eine Leiterplatte, beispielsweise eine Leiterkarte, Platine oder gedruckte Schaltung sein. Die Steckkarte kann quaderförmig sein, wobei die Arbeitsflächen und / oder Schmalseiten eine beliebige viereckige Form aufweisen können, insbesondere eine rechteckige oder quadratische Form. Die Schmalseiten können zueinander und zu den Arbeitsflächen orthogonal angeordnet sein. Die Arbeitsflächen der Steckkarte können ein Träger für elektronische Bauteile sein. Die Steckkarte dient der mechanischen Befestigung und elektrischen Verbindung. Die Steckkarte kann aus einem elektrisch isolierenden Material bestehen, beispielsweise faserverstärkter Kunststoff, und eine leitende Verbindung bzw. eine Leiterbahn umfassen. Die Leiterbahn kann aus einer dünnen Schicht Kupfer geätzt sein. Die Bauelemente können beispielsweise auf Lötflächen oder in Lötaugen gelötet oder eingepresst sein.

In Ausgestaltung der Erfindung ist der Kontakthalter derart ausgestaltet und angeordnet, dass ein erstes Kontaktelement eine der Arbeitsflächen kontaktiert und / oder ein zweites Kontaktelement eine Frontplatte mit Führungsstift und / oder ein mit der Frontplatte verbundenes Metallteil der Einschubeinheit kontaktiert.

Das erste Kontaktelement kann an einem seitlichen Führungshalter in einem Einführbereich der Steckkarte angeordnet sein, wobei das erste Kontaktelement eine der Arbeitsfläche kontaktiert. Das erste Kontaktelement kann als ein Teil des seitlichen Führungshalters ausgebildet sein. Das erste Kontaktelement kann ein Federelement umfassen. Das Federelement kann eine Anlagekontaktsteile und nach der Anlagekontaktsteile eine Anziehschräge bildenden Endabschnitt umfassen, sodass das Herausziehen der Steckkarte vorteilhafterweise erleichtert ist. Beim Einstecken der Steckkarte kann das Federelement ausgelenkt werden und die Anlagekontaktsteile kann eine elektrische Verbindung mit der Steckkarte, insbesondere der Arbeitsfläche herstellen. Zusätzlich stellt die Anziehschräge vorteilhafterweise sicher, dass sich der Endabschnitt des ersten Kontaktelements nicht an dem Führungshalter verhaken kann.

Das zweite Kontaktelement kann am Verbindungssteg oder aber am Führungselement angeordnet sein. Das zweite Kontaktelement kann ebenso wie das erste Kontaktelement ausgebildet sein oder kann als gebogenes oder als flaches rechteckiges Federelement ausgebildet sein. Der Kontakthalter kann einteilig sein, also das erste und zweite Kontaktelement können einstückig sein, oder aber zweit- oder mehrstückig. Das erste und zweite Kontaktelement können, da die Kartenführung einteilig ist, ein integraler Bestandteil der Kartenführung sein.

In Ausgestaltung der Erfindung umfasst die Kartenführung mindestens zwei Führungselemente und zwei Kontakthalter, wobei die Führungselemente bevorzugt parallel angeordnet sind. Ausserdem sind die zwei Führungselemente mittels Verbindungselementen miteinander verbunden. Die Kartenführung kann pro Baugruppenträger bis zu 84 Führungselemente aufweisen. Dabei kann der Baugruppenträger frontseitig 21 Einschubslots und Rückseitig 21 Einschubslots umfassen, wobei ein Slot zwei Führungselemente und zwei Kontakthalter umfassen kann. Die Führungselemente können parallel angeordnet sein. Die Führungselemente können mittels Verbindungselementen miteinander und / oder dem Verbindungssteg miteinander verbunden sein. Somit wird der Montageaufwand erheblich verringert.

In Ausgestaltung der Erfindung umfasst die Kartenführung zusätzlich ein oder mehrere Befestigungselemente, um die Kartenführung mittels des Befestigungselements an einem Profil des Baugruppenträgers zu befestigen. Das oder die Befestigungselemente sind als Federelemente zum Einrasten oder Einklipsen in einem Profil des Baugruppenträgers oder als Verbindungselemente zum Schweissen, Löten, Kleben oder Nieten ausgebildet. Das Befestigungselement kann am Führungselement, insbesondere am Führungsfuss, befestigt sein. Das Befestigungselement kann als Ausnehmung oder aber als Feder ausgebildet sein, sodass vorteilhafterweise eine einfach Montage der Kartenführung möglich ist.

In Ausgestaltung der Erfindung ist die Kartenführung aus einem elektrisch leitenden Material, insbesondere Stahlblech oder Federblech geformt. Es ist aber auch möglich, dass die Kartenführung aus einem nicht elektrisch leitenden Material ist und mit einem elektrisch leitenden Material beschichtet ist. Die Kartenführung kann somit aus einem leitenden Material oder aus einem nicht leitenden Material sein. Die Kartenführung kann aus Metall sein, insbesondere aus Stahlblech, Federblech, Alublech oder Kupferblech. Die Kartenführung kann aber auch aus einem nicht elektrisch leitenden Material, beispielsweise aus Kunststoff mit einem Spritzgussverfahren, hergestellt sein und mit einem leitenden Material beschichtet sein. Vorteil ist, dass die Kartenführung inklusive Kontakthalter einstückig ausgeführt sein kann und gleichzeitig die elektrisch leitende Eigenschaften und Aufgaben des Kontakthalters ein integraler Bestandteil der Kartenführung sind. Zusätzlich wird auch hier der Montageaufwand reduziert.

In Ausgestaltung der Erfindung ist mindestens ein weiteres Kontaktierelement vorgesehen ist, um beide Arbeitsflächen zu kontaktieren. Eine Ausgestaltung des weiteren Kontaktelements kann wie das erste Kontaktelement entsprechen. Das weitere Kontaktelement kann beispielsweise als ein Federelement am Führungshalter angeordnet sein und mit einem Federblatt in die Führungsschiene ragen. Das erste und das weitere Kontaktelement können eine oder jeweils eine der Arbeitsflächen der Steckkarte mit der Kartenführung kontaktieren. Vorteilhafterweise können somit beide Arbeitsflächen kontaktiert werden.

In Ausgestaltung der Erfindung ist die Kartenführung aus einem Band gefertigt. Eine Teilung im Band entspricht dem Rasterabstand einer Einschubeinheit. Die Kartenführung erstreckt sich in Einschubrichtung über mindestens ein Zehntel der Einschublänge. Vorteilhafterweise kann so die gesamte Kartenführung in einem einfachen Stanz-Biege-Vorgang aus einem plattenförmigen Basisteil hergestellt werden. Die Einsparung ergibt sich somit aus der billigeren Herstellung, da nicht mehr drei Bauteile, also beispielsweise Kartenführung aus Kunststoff und zwei Kontaktierungen, sondern nur noch ein einstückiges Bauteil hergestellt wird. Ein weiterer Vorteil liegt in der verkürzten Montagezeit, da sich diese auf bis zu ein zehntel der vorher benötigten Zeit reduzieren kann.

Die Erfindung betrifft im Weiteren einen Baugruppenträger mit einer oder mehreren Kartenführungen.

Der Baugruppenträger kann zwei Seitenwänd umfassen, die die Breite festlegen. Der Baugruppenträger kann ein Kopfteil und ein Bodenteil umfassen, die die Höhe des Baugruppenträgers bestimmen. Das Kopfteil und das Bodenteil können einstückig oder mehrstückig sein. Der Baugruppenträger kann eine oder mehrere nebeneinander angeordnete und in Einschubrichtung ausgerichtete Kartenführungen aufweisen. Der Baugruppenträger kann im Weiteren einen umlaufenden Rahmen umfassen. Im Baugruppenträger können eine oder mehrere Steckkarten angeordnet sein.

In Ausgestaltung der Erfindung umfasst der Baugruppeträger mehreren einzelne Kartenführungen. Die Kartenführungen sind im Rasterabstand der entsprechenden Einschubeinheiten.

Weitere vorteilhafte Massnahmen und bevorzugte Verfahrensführungen ergeben sich aus den abhängigen Ansprüchen.

Im Folgenden wird die Erfindung sowohl in apparativer als auch in verfahrenstechnischer Hinsicht anhand von Ausführungsbeispielen unter Bezugnahme auf die Zeichnung näher erläutert. In der schematischen Zeichnung zeigen:
- Fig. 1: eine Seitenansicht eines ersten Ausführungsbeispiel der Kartenführung;
- Fig. 2: eine weitere Ansicht des ersten Ausführungsbeispiel der Kartenführung;
- Fig. 3: einen schematische Darstellung eines Ausschnittes aus einem Baugruppenträger.

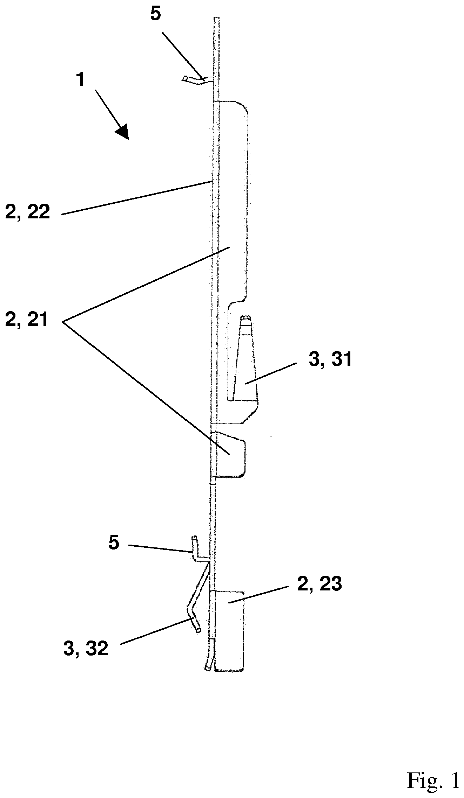

Fig. 1 zeigt ein erstes Ausführungsbeispiel der Kartenführung 1. Die Kartenführung umfasst ein Führungselement 2 und einen Kontakthalter 3. Das Führungselement 2 wiederum umfasst mehrere seitlich angeordnete Führungshalter 21 und einen Führungsfuss 22. Der Führungsfuss 22 ist als eine ebene Gleitfläche für eine der vier orthogonalen Schmalseiten der Steckkarte ausgeführt und die seitlichen Führungshalter 21 sind zur Führung und Stabilisierung der Arbeitsfläche der Steckkarte. Der Führungsfuss 22 ist eine rechteckige ebene Gleitfläche und einstückig ausgeführt. Es sind mehrere Führungshalter 21 vorgesehen, die am Führungsfuss 22 angeordnet und befestigt sind. In diesem ersten Ausführungsbeispiel sind zusätzlich mehrere Führungshalter 23 an einer Einführseite der Kartenführung angeordnet, die mit den einander zugekehrten Seiten im spitzen Winkel zueinander stehen, der sich zur Einführseite hin öffnet. Die Führungshalter 23 bilden somit eine mit einer Einführschräge versehene Einführaufnahme aus, so dass die Steckkarte 8 schon beim Ansetzen an den Anfang des Führungsfusses 22 eine Art Zwangspositionierung und Einführung in das Führungselement 2 erhalten. Dies erleichtert das Bestücken des Baugruppenträgers.

Der Kontakthalter 3 umfasst ein erstes Kontaktelement 31 und ein zweites Kontaktelement 32. Das erste Kontaktelement 31 ist in einer Ausnehmung des Führungshalters 21 angeordnet und als ein Federelement ausgebildet. Eine am ersten Kontaktelement 31 ausgebildete Anlagekontaktsteile ragt am weitesten in das Führungselement 2. Wird eine Leiterplatte einer Steckkarte eingeschoben, dann wird das Federelement ausgelenkt und die Anlagekontaktsteile stellt eine elektrische Verbindung her. Das zweite Kontaktelement 32 ist am Führungsfuss 22 angeordnet. Eine weitere Anlagenkontaktsteile im Einbauzustand stellt eine elektrische Verbindung in Richtung einer Frontplatte und / oder einen Führungsstift und / oder ein mit der Frontplatte verbundenes Metallteil der Einschubeinheit her. Die Kartenführung 1 umfasst zwei Befestigungselemente 5, um die Kartenführung mittels der Befestigungselemente an einem Profil des Baugruppenträgers 8 zu befestigen und mit der Kartenführung verbunden.

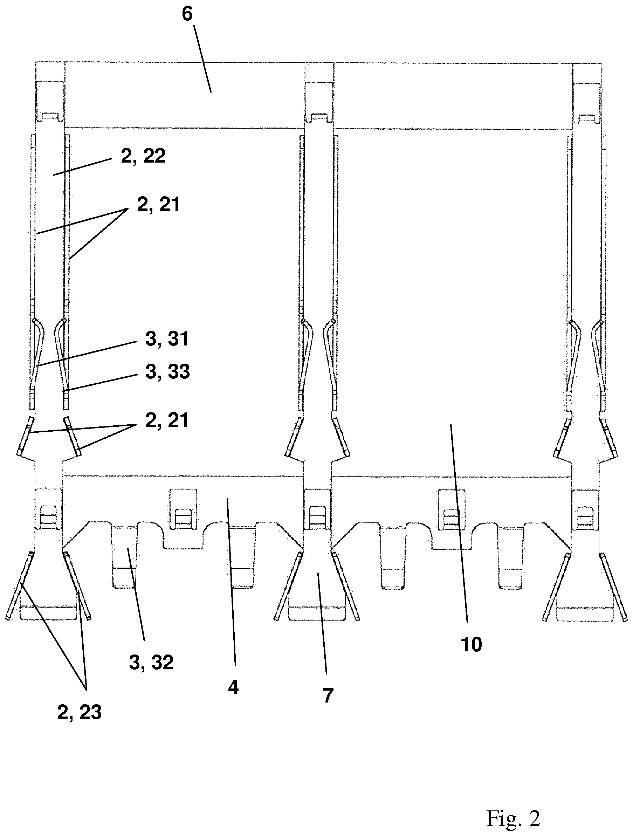

In Fig. 2 ist ein Ausschnitt eines Baugruppenträgers 9 schematisch dargestellt. Der Aufbau der Kartenführung 1 weist viele Gemeinsamkeiten mit der Kartenführung 1 aus Fig. 1 auf, weshalb nur auf die Unterschiede eingegangen wird. Die Kartenführung 1 umfasst drei Führungselemente 2 und drei Kontakthalter 3, wobei die Führungselemente 2 bevorzugt parallel angeordnet sind. Die Führungselemente 2 sind mittels Verbindungselemente 6 miteinander verbunden. Der Führungsfuss 22 und die seitlichen Führungshalter 21 sind als eine Führungsschiene ausgebildet und mehre Führungselemente 2 sind parallel ausgerichtet. Im Aufnahmebereich der Steckkarte ist ein Paar von Führungshaltern 23 pro Führungselement 2 als eine Einführaufnahme ausgebildet. Außerhalb der Führungselemente 2 ist die Kartenführung 1 mit Durchbrüchen 10 versehen. Pro Führungselement 2 sind zwei Reihen von Führungshaltern 21, 23 vorgesehen. Die Führungshalter 21, 23 der beiden Reihen eines Führungselements stehen in Einschubrichtung paarweise einander gegenüber und sind mit einem gleichen Abstand angeordnet. Der Abstand ist an die Dicke der Steckkarte 8 derart angepasst, dass eine Einschubreibung für die Steckkarte klein gehalten wird.

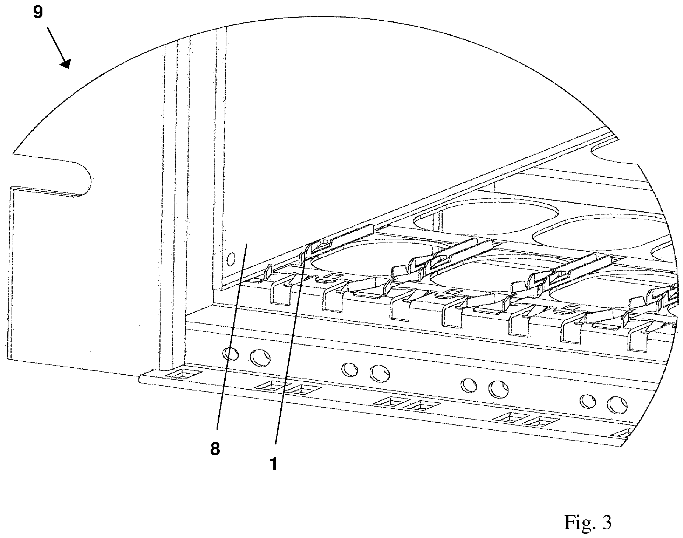

In Fig. 3 ist ein Ausschnitt eines Baugruppenträgers 9 schematisch dargestellt. Der Aufbau der Kartenführung 1 entspricht im Wesentlichen der Kartenführung 1 aus Fig. 1. Der Baugruppenträger 9 umfasst zwei Seitenwände (nicht dargestellt), die die Breite festlegen. Ein Kopf- und ein Bodenteil (nicht dargestellt) den Baugruppenträger 9 und bestimmen die Höhe desselben. Wie der Fig. 1 zu entnehmen ist, ist die Kartenführung 1 einteilig, die mehrere Führungselemente und Kontaktelemente umfasst, ausgeführt. Die Führungselemente sind nebeneinander und in Einschubrichtung ausgerichtet. Ein umlaufender Rahmen (nicht dargestellt) verbindet eine Vorder- und Rückseite des Baugruppenträgers 9. Die Kartenführung 1 ist mittels der Befestigungselemente (siehe Fig 1.) am Baugruppenträger 1 befestigt. Die Steckkarte 8 ist in die Kartenführung 1 eingesteckt.

## Patentansprüche

1. Kartenführung (1) für einen Baugruppenträger (9) zum Führen und Halten einer zu einer Einschubeinheit gehörenden Steckkarte (8), wobei die Steckkarte (8) zwei gegenüberliegende Arbeitsflächen und vier orthogonale Schmalseiten aufweist, und die Kartenführung (1) ein Führungselement (2) und einen Kontakthalter (3) umfasst, wobei das Führungselement (2) einen Führungsfuss (22) aufweist, um eine sich in eine Einschubrichtung erstreckende Schmalseite der Steckkarte (8) zu führen, und das Führungselement (2) einen seitlichen Führungshalter (23) zur Führung der Arbeitsflächen aufweist, und wobei die Kartenführung (1) einteilig ausgeführt ist, **dadurch gekennzeichnet, dass** der Kontakthalter (3) derart ausgestaltet und angeordnet ist, dass ein erstes Kontaktelement (31) des Kontakthalters (3) mit einer der Arbeitsflächen der Steckkarte kontaktierbar ist und ein zweites Kontaktelement (32) des Kontakthalters (3) mit einer Frontplatte mit Führungsstift und / oder mit einem mit der Frontplatte verbundenem Metallteil der Einschubeinheit kontaktierbar ist.

2. Kartenführung nach Anspruch 1, wobei die Kartenführung (1) mindestens zwei Führungselemente (2) und zwei Kontakthalter (3) umfasst, wobei die Führungselemente (2) bevorzugt parallel angeordnet sind.

3. Kartenführung nach Anspruch 2, wobei die zwei Führungselemente (2) mittels Verbindungselementen (6) miteinander verbunden sind.

4. Kartenführung nach einem der vorangehenden Ansprüche, wobei die Kartenführung (1) zusätzlich ein oder mehrere Befestigungselemente (5) umfasst, um die Kartenführung (1) mittels des Befestigungselements (5) an einem Profil des Baugruppenträgers (9) zu befestigen.

5. Kartenführung nach Anspruch 4, wobei das oder die Befestigungselemente (5) als Federelemente zum Einrasten oder Einklipsen in einem Profil des Baugruppenträgers (9) oder als Verbindungselemente zum Schweissen, Löten, Kleben oder Nieten ausgebildet sind.

6. Kartenführung nach einem der vorangehenden Ansprüche, wobei die Kartenführung (1) aus einem elektrisch leitenden Material, insbesondere Stahlblech oder Federblech geformt ist.

7. Kartenführung nach einem der vorangehenden Ansprüche, wobei die Kartenführung (1) aus einem nicht elektrisch leitenden Material ist und mit einem elektrisch leitenden Material beschichtet ist.

8. Kartenführung nach einem der vorangehenden Ansprüche, wobei mindestens ein weiteres erstes Kontaktelement (31) vorgesehen ist, um beide Arbeitsflächen zu kontaktieren.

9. Kartenführung nach einem der vorangehenden Ansprüche, wobei sich die Kartenführung (1) in Einschubrichtung über mindestens einen Zehntel einer Einschublänge erstreckt.

10. Baugruppenträger mit einer oder mehreren Kartenführungen (1) nach einem der Ansprüche 1 bis 9.

11. Baugruppeträger nach Anspruch 10 mit mehreren einzelnen Kartenführungen (1).

12. Baugruppeträger nach einem der Ansprüche 10 oder 11, wobei die Kartenführungen (1) im Rasterabstand der entsprechenden Einschubeinheiten sind.

## Claims

1. A card guide (1) for a rack (9) for guiding and holding a plug-in card (8) belonging to a plug-in unit, wherein the plug-in card (8) has two oppositely disposed working surfaces and four orthogonal narrow sides and the card guide (1) comprises a guide element (2) and a contact holder (3), wherein the guide element (2) has a guide base (22) to guide a narrow side of the plug-in card (8) extending in a plug-in direction, and the guide element (2) has a lateral guide holder (23) for guiding the working surfaces, wherein the card guide (1) is configured in one part, **characterized in that** the contact holder (3) is configured and arranged such that a first contact element (31) can be contacted with one of the working surfaces and a second contact element (32) can be contacted with a front plate with a guide pin and/or a metal part of the plug-in unit connected to the front plate.

2. A card guide in accordance with claim 1, wherein the card guide (1) comprises at least two guide elements (2) and two contact holders (3), wherein the guide elements (2) are preferably arranged in parallel.

3. A card guide in accordance with claim 2, wherein the two guide elements (2) are connected to one another by means of connection elements (6).

4. A card guide in accordance with any one of the preceding claims, wherein the card guide (1) additionally comprises one or more fastening elements (5) to fasten the card guide (1) to a section of the rack (9) by means of the fastening element (5).

5. A card guide in accordance with claim 4, wherein the fastening element or elements (5) are configured as spring elements for latching or clipping in a section of the rack (9) or as connection elements for welding, soldering, adhesive bonding or riveting.

6. A card guide in accordance with any one of the preceding claims, wherein the card guide (1) is formed from an electrically conductive material, in particular from sheet metal or spring plate.

7. A card guide in accordance with any one of the preceding claims, wherein the card guide (1) is composed of a non-electrically conductive material and is coated with an electrically conductive material.

8. A card guide in accordance with any one of the preceding claims, wherein at least one further first contact element (31) is provided to contact both working surfaces.

9. A card guide in accordance with any one of the preceding claims, wherein the card guide (1) extends over at least a tenth of a plug-in length in the plug-in direction.

10. A rack having one or more card guides (1) in accordance with any one of the claims 1 to 9.

11. A rack in accordance with claim 10 having a plurality of individual card guides (1).

12. A rack in accordance with one of the claims 10 or 11, wherein the card guides (1) are arranged in the grid spacing of the corresponding plug-in units.

## Revendications

1. Guide-carte (1) pour un châssis (9), pour guider et maintenir une carte enfichable (8) appartenant à une unité de tiroir insérable, dans lequel la carte enfichable (8) présente deux surfaces de travail opposées et quatre côtés courts orthogonaux, et le guide-carte (1) présente un élément de guidage (2) et un support de contact (3), dans lequel l'élément de guidage (2) présente un pied de guidage (22) pour guider un côté court s'étendant une direction d'insertion de la carte enfichable (8), et l'élément de guidage (2) présente un support de guidage latéral (23) pour guider les surfaces de travail, et dans lequel le guide-carte (1) est réalisé en une seule pièce, **caractérisé en ce que** le support de contact (3) est configuré et agencé de telle sorte qu'un premier élément de contact (31) du support de contact (3) peut être mis en contact avec l'une des surfaces de travail de la carte enfichable, et un second élément de contact (32) du support de contact (3) peut être mis en contact avec une plaque frontale avec une broche de guidage et/ou avec une partie métallique reliée à la plaque frontale de l'unité de tiroir insérable.

2. Guide-carte selon la revendication 1, dans lequel le guide-carte (1) présente au moins deux éléments de guidage (2) et deux supports de contact (3), dans lequel les éléments de guidage (2) sont disposés de préférence en parallèle.

3. Guide-carte selon la revendication 2, dans lequel les deux éléments de guidage (2) sont reliés entre eux au moyen d'éléments de liaison (6).

4. Guide-carte selon l'une quelconque des revendications précédentes, dans lequel le guide-carte (1) présente en outre un ou plusieurs éléments de fixation (5), pour fixer le guide-carte (1) au moyen de l'élément de fixation (5) sur un profil du châssis (9).

5. Guide-carte selon la revendication 4, dans lequel le ou les éléments de fixation (5) sont conçus comme des éléments à ressort pour encliquetage ou clipsage dans un profil du châssis (9) ou comme des éléments de liaison pour un soudage, un brasage, un collage ou un rivetage.

6. Guide-carte selon l'une quelconque des revendications précédentes, dans lequel le guide-carte (1) est formé à partir d'un matériau électriquement conducteur, en particulier une tôle d'acier ou tôle élastique.

7. Guide-carte selon l'une quelconque des revendications précédentes, dans lequel le guide-carte (1) est en un matériau non conducteur de l'électricité, et est recouvert d'un matériau électriquement conducteur.

8. Guide-carte selon l'une quelconque des revendications précédentes, dans lequel au moins un premier élément de contact supplémentaire (31) est prévu, pour mettre en contact les deux surfaces de travail.

9. Guide-carte selon l'une quelconque des revendications précédentes, dans lequel le guide-carte (1) s'étend dans la direction d'insertion sur au moins un dixième d'une longueur d'insertion.

10. Châssis avec un ou plusieurs guides-cartes (1) selon l'une quelconque des revendications 1 à 9.

11. Châssis selon la revendication 10, ayant plusieurs guides-cartes individuels (1).

12. Châssis selon la revendication 10 ou 11, dans lequel les guides-cartes (1) sont à une distance de l'une unité de tiroir insérable correspondante.
